# EUROPÄISCHE PATENTSCHRIFT

(11) **EP 2 466 596 B1**
(45) Veröffentlichungstag und Bekanntmachung des Hinweises auf die Patenterteilung: **28.08.2013**
(21) Anmeldenummer: 10195286.9
(22) Anmeldetag: 16.12.2010
(51) Int. Cl.: H01C 7/12

(54) **Bauteil mit Überspannungsschutz und Verfahren zu dessen Prüfung**
Component with excess voltage protection and method for testing same
Composant doté d'une protection contre les surtensions et leur procédé de contrôle

(43) Veröffentlichungstag der Anmeldung: 20.06.2012
(73) Patentinhaber: ABB Research Ltd., 8050 Zürich (CH)
(72) Erfinder: Fuechsle, Dieter, 5304 Endingen (CH); Neeser, Daniel, 8800 Thalwil (CH); Doser, Bernhard, 79761 Waldshut-Tiengen (DE); Müller, Daniel, 8046 Zürich (CH); Ljuslinder, Marlene, 5408 Endingen (CH); Greuter, Felix, 5406 Baden-Rütihof (CH)
(74) Vertreter: ABB Patent Attorneys

(56) Entgegenhaltungen:
- EP-A1- 1 603 141

## Beschreibung

Die Erfindung betrifft ein Verfahren zum Durchführen eines Überspannungstests in einer Schaltungsanordnung, an welcher mindestens ein Überspannungsableiter angeschlossen ist. Weiter betrifft die Erfindung ein Bauteil mit Überspannungsschutz zum Durchführen dieses Verfahrens.

### Hintergrund

In Hochspannungssystemen werden Überspannungsableiter dazu eingesetzt, unzulässige Überspannungen gegen Erde abzuleiten. Typisch besitzen derartige Überspannungsableiter einen Varistor, welcher bei niederen Spannungen eine hohe Impedanz aufweist, der aber bei unzulässigen Überspannungen zu leiten beginnt und so in der Lage ist, die Überspannung zu begrenzen.

Um Hochspannungssysteme zu testen, wird während einer Testphase eine Testspannung (Prüfspannung) an das System angeschlossen und es wird geprüft, ob das System dieser Spannung standzuhalten vermag. Dabei ist darauf zu achten, dass ein am Hochspannungssystem angeschlossener Überspannungsableiter nicht auf die Testspannung anspricht, denn er könnte ansonsten die Testspannung begrenzen oder durch die Testspannung beschädigt werden. Deshalb werden Überspannungsableiter während der Testphase normalerweise entfernt.

Insbesondere bei gasisolierten Aufbauten, bei denen die Hochspannungssysteme sowie auch die Überspannungsableiter gasisoliert sind, ist ein Entfernen des Überspannungsableiters zur Durchführung eines Überspannungstests jedoch äusserst aufwändig.

### Darstellung der Erfindung

Es stellt sich deshalb die Aufgabe, ein Verfahren und einen Bauteil der eingangs genannten Art bereitzustellen, welche es erlauben, die Überspannungstests einfacher zu gestalten.

Diese Aufgabe wird vom Verfahren bzw. vom Bauteil gemäss den unabhängigen Ansprüchen erfüllt.

Demgemäss bezieht sich die Erfindung auf ein Verfahren zum Durchführen eines Überspannungstests in einer Schaltungsanordnung, an welche mindestens ein Überspannungsableiter angeschlossen ist. Dieser Überspannungsableiter weist einen Varistor auf, welcher an einen ersten Anschluss über eine erste Leitung auf Hochspannungspotenzial liegt und an einem zweiten Anschluss über eine zweite Leitung mit Erde verbunden werden kann. Während einer Testphase wird eine Testspannung an die Schaltungsanordnung angelegt. Um zu vermeiden, dass der Varistor auf die Testspannung anspricht, werden dabei die folgenden Schritte durchgeführt:
- Vor der Testphase wird die erste oder zweite Leitung unterbrochen.
- Während der Testphase wird, abhängig davon, ob zuvor die erste oder die zweite Leitung unterbrochen wurde, einer der folgenden Schritte verwendet:
   a) Wurde vorher die zweite (erdungsseitige) Leitung unterbrochen, so bleibt der erste Anschluss mit der Schaltungsanordnung verbunden, während der zweite Anschluss über eine Zusatzimpedanz mit der Erde verbunden ist.
   b) Wurde vorher die erste (hochspannungsseitige) Leitung unterbrochen, so bleibt der zweite Anschluss mit Erde verbunden, während der erste Anschluss über die Zusatzimpedanz mit der Schaltungsanordnung, d.h. mit Hochspannung, verbunden ist.

In beiden Fällen weist die Zusatzimpedanz höhere Impedanz als die unterbrochene Leitung auf.
- Nach der Testphase wird die Unterbrechung der ersten bzw. zweiten Leitung wieder aufgehoben, so dass der Überspannungsableiter wieder seine normale Schutzfunktion übernimmt.

Die Aufgabe der Zusatzimpedanz liegt dabei darin, während der Testphase mit dem Varistor zusammen eine genügend hohe Impedanz aufzubauen, so dass der Überspannungsableiter nicht anspricht, was zu einer Überbelastung oder einer Limitierung der Prüfspannung führen könnte. Im Gegensatz zu bekannten Lösungen ist es aber nicht notwendig, den Varistor völlig von der Hochspannung abzukoppeln.

Aus der Druckschrift EP 1603141 A1 ist ein Bauteil gemäß der Oberbegriffe der unabhängigen Ansprüche bekannt.

Vorzugsweise wird die zweite (erdseitige) Leitung unterbrochen und die Zusatzimpedanz zwischen dem zweiten Anschluss und der Erde angeordnet. In diesem Fall erlaubt es die Zusatzimpedanz, während der Testphase das Potenzial am erdseitigen, zweiten Anschluss des Varistors gegenüber der Testspannung zu reduzieren, so dass in diesem Bereich ein Durchschlag vermieden wird.

Das Bauteil gemäss der vorliegenden Erfindung besitzt die folgenden Komponenten:
- Ein Varistor dient in bekannter Weise dazu, Überspannungen abzubauen, d.h. seine Impedanz nimmt oberhalb einer Grenzspannung stark ab. Er besitzt einen ersten Anschluss, über den er mit Hochspannungspotenzial verbunden wird, sowie einen zweiten Anschluss, um ihn mit Erde zu verbinden.
- Eine erste Leitung ist vorgesehen, um den ersten Anschluss mit Hochspannungspotenzial zu verbinden.
- Eine zweite Leitung ist vorgesehen, um den zweiten Anschluss mit Erde, d.h. Erdpotenzial, zu verbinden.
- Weiter ist eine Zusatzimpedanz vorgesehen, welche eine höhere Impedanz als die erste oder zweite Leitung aufweist, und welche zwischen dem ersten Anschluss und der Hochspannung oder dem zweiten Anschluss und der Erde angeordnet werden kann. Die Zusatzimpedanz erhöht in der oben beschriebenen Weise die Impedanz des Überspannungsableiters während der Testphase.

Ein Bauteil dieser Art kann z.B. ein Überspannungsableiter sein, oder ein Gerät, das einen solchen Überspannungsableiter enthält, wie z.B. eine Durchführung mit Überspannungsschutz.

Bevorzugt ist eine mechanische Schaltanordnung vorgesehen. Diese erlaubt es, in einfacher Weise die erste oder zweite Leitung während der Testphase zu unterbrechen.

Bevorzugt ist die Anordnung der Zusatzimpedanz zwischen dem zweiten Anschluss und der Erde, wobei mit der Schaltanordnung die zweite Leitung unterbrochen werden kann. Mit anderen Worten wird in dieser Ausführung die Zusatzimpedanz somit erdseitig in Serie zum Varistor eingefügt, was einfacher realisiert werden kann. Denkbar ist jedoch auch die Anordnung auf der Hochspannungsseite des Varistors, wobei in diesem Fall mit der Schaltanordnung die erste Leitung unterbrochen werden kann. Weiter ist auch denkbar, eine Zusatzimpedanz erdseitig und eine andere Zusatzimpedanz hochspannungsseitig anzuordnen, wobei mit der Schaltanordnung die erste und die zweite Leitung unterbrochen werden können.

Vorteilhaft wird die Zusatzimpedanz derart bemessen, dass während der Testphase der Spannungsabfall über dem Varistor eine zulässige Varistor-Maximalspannung für eine bestimmte Prüfdauer nicht übersteigt, auch wenn die Testspannung höher als die Varistor-Maximalspannung ist. Damit kann sichergestellt werden, dass der Varistor nicht übermässig Strom zieht.

In einer vorteilhaften Ausführung sind die Zusatzimpedanz und vorzugsweise auch die Schaltanordnung in der Kapselung angeordnet. Dadurch kann auf eine spannungsfeste Durchführung verzichtet werden, und zudem kann das in der Kapselung angeordnete Schutzgas auch Überschläge im Bereich der Zusatzimpedanz verhindern.

Alternativ kann die Zusatzimpedanz auch ausserhalb der Kapselung angeordnet werden. In diesem Fall ist ein Erdungsanschluss von Vorteil, der mit dem zweiten (erdseitigen) Anschluss des Varistors verbunden ist und sich durch eine isolierende Durchführung der Kapselung erstreckt. Die Anordnung der Zusatzimpedanz ausserhalb der Kapselung erlaubt eine leichtere Zugänglichkeit. Zudem ist es in diesem Fall in einfacher Weise möglich, die Zusatzimpedanz zu entfernen, wenn sie nach der Testphase nicht mehr benötigt wird.

Bei gasisolierten Bauteilen ist dabei unter "Kapselung" eine gasdichte Kapselung zu verstehen, welche das isolierende Gas umgibt. Anderenfalls ist der Begriff Kapselung als Gehäuse oder Aussenfläche des Bauteils zu verstehen. Die Erfindung ist jedoch auch bei flüssigkeitsisolierten oder feststoffisolierten Teilen anwendbar.

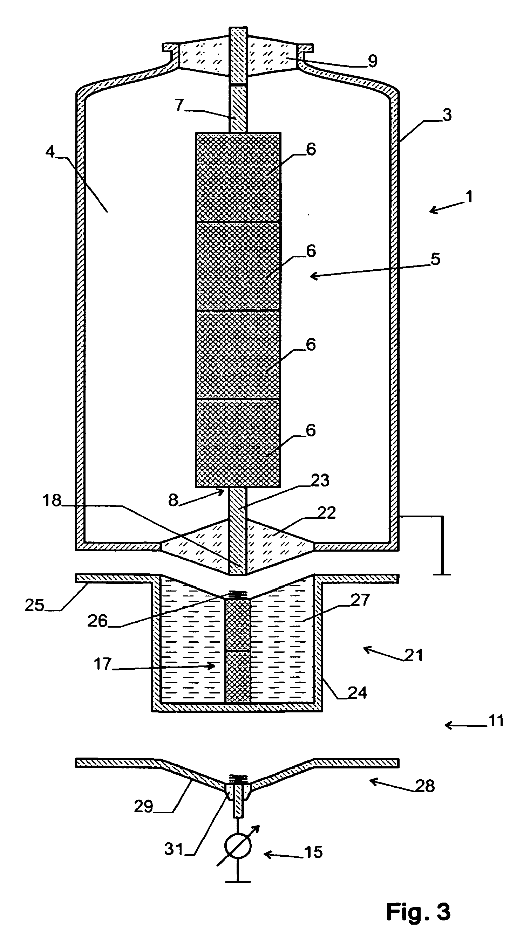

Der Begriff "mechanische Schaltanordnung" ist im vorliegenden Kontext so zu verstehen, dass er sowohl einen eigentlichen Schalter umfasst, aber auch einen Trennmechanismus, der es erlaubt, die erste bzw. zweite Leitung durch Anbau und/oder Abbau von Teilen des Überspannungsableiters zu unterbrechen, z.B. im Sinne der Ausführung gemäss der unten beschriebenen Fig. 3.

Besonders vorteilhaft ist die Erfindung bei einer gas-, flüssigkeits- oder feststoffisolierten Schaltungsanordnung mit gas-, flüssigkeits- oder feststoffisoliertem Überspannungsableiter, da dort ein Ausbau des Überspannungsableiters für die Testphase besonders aufwändig wäre. Das erfindungsgemässe Prinzip ist aber auch für andere Überspannungsableiter sinngemäss anwendbar, und auch für nicht gas-, flüssigkeits- oder feststoffisolierte Schaltungsanordnungen.

### Kurze Beschreibung der Zeichnungen

Weitere Ausgestaltungen, Vorteile und Anwendungen der Erfindung ergeben sich aus den abhängigen Ansprüchen und aus der nun folgenden Beschreibung anhand der Figuren. Dabei zeigen:
Fig. 1 eine erste Ausführung eines Überspannungsableiters,
Fig. 2 eine zweite Ausführung eines Überspannungsableiters,
Fig. 3 eine dritte Ausführung eines Überspannungsableiters,
Fig. 4 eine vierte Ausführung eines Überspannungsableiters,
Fig. 5 eine fünfte Ausführung eines Überspannungsableiters mit Drehschalter,
Fig. 6 eine sechse Ausführung eines Überspannungsableiters mit Drehschalter,
Fig. 7 eine siebte Ausführung eines Überspannungsableiters mit Kippschalter,
Fig. 8 eine achte Ausführung eines Überspannungsableiters mit seitlichem Metallstift,
Fig. 9 eine erste Ausführung eines Überspannungsableiters in einer Hochspannungsdurchführung,
Fig. 10 eine zweite Ausführung eines Überspannungsableiters in einer Hochspannungsdurchführung im Normalbetrieb,
Fig. 11 die Ausführung nach Fig. 10 im Testbetrieb,
Fig. 12 eine dritte Ausführung eines Überspannungsableiters in einer Hochspannungsdurchführung im Normalbetrieb,
Fig. 13 die Ausführung nach Fig. 12 im Testbetrieb,
Fig. 14 ein Hochspannungsbauteil mit integrierten Überspannungsableiter während der Testphase,
Fig. 15 das Bauteil nach Fig. 14 im Normalbetrieb,
Fig. 16 eine Detailvariante zu Fig. 5,

### Wege zur Ausführung der Erfindung

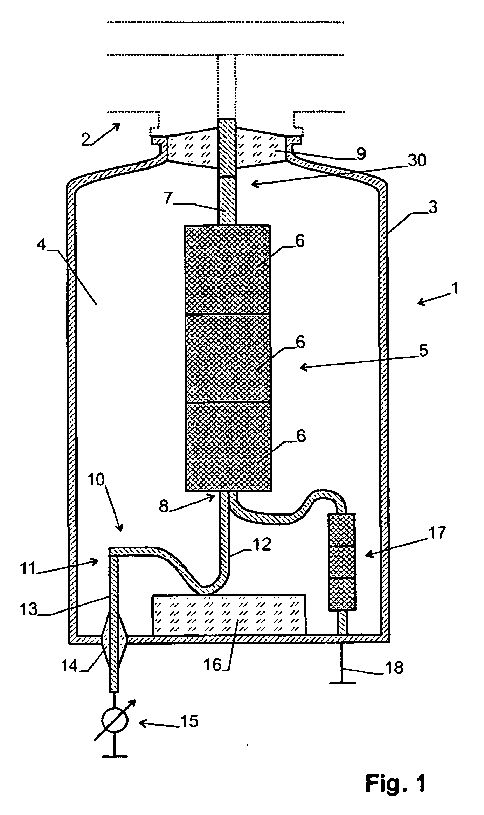

Fig. 1 zeigt einen gasisolierten Überspannungsableiter 1, der an eine gestrichelt dargestellte, ebenfalls gasisolierte Schaltungsanordnung 2 angeschlossen ist. Bei der Schaltungsanordnung 2 kann es sich um irgendeine Hochspannung führende Anordnung handeln, wie z.B. um einen gasisolierten Schalter, einen Transformator oder ein anderes Gerät. Die Schaltanordnung 2 kann für Gleichspannung, Wechselspannung oder deren Überlagerungen sowie für andere Spannungsformen ausgelegt sein.

Der Überspannungsableiter 1 besitzt eine gasdichte Kapselung 3 aus Metall, deren Innenraum 4 mit einem Schutzgas, wie z.B. SF₆, unter Überdruck gefüllt ist. In der Kapselung 3 ist ein Varistor 5 angeordnet. Dieser Varistor, welcher aus einem oder mehreren Einzelkörpern 6 zusammengesetzt ist, bildet eine spannungsabhängige Impedanz, z.B. auf der Basis von Metalloxid, insbesondere aus geeignet dotiertem ZnO. Die Einzelkörper 6 sind in bekannter Weise mechanisch und elektrisch miteinander verbunden.

Der Varistor 5 besitzt einen ersten, hochspannungsseitigen Anschluss 7, sowie einen zweiten, erdseitigen Anschluss 8. Der erste Anschluss 7 ist über eine erste Leitung 30 durch eine isolierende Durchführung 9 mit der Schaltungsanordnung 2 verbunden. Der zweite Anschluss 8 ist über eine zweite Leitung 10 (im Folgenden auch Erdleitung genannt) und eine mechanisch betätigbare Schaltanordnung 11 mit Erde, d.h. Erdpotenzial, verbunden.

Die Erdleitung 10 umfasst in der gezeigten Ausführung einen Leiterabschnitt 12 aus Metall sowie einen Metallstift 13. Der Metallstift 13 ist längsverschiebbar in einer gasdichten, elektrisch isolierenden Durchführung 14 angeordnet. Sein äusseres Ende ist über ein optionales Messgerät 15 mit Erde verbunden.

Der Leiterabschnitt 12 und der Metallstift 13 bilden zusammen einen in der Kapselung 3 angeordneten Schalter der Schaltanordnung 11, mit welchem die Erdleitung 10 unterbrochen werden kann. Befindet sich der Metallstift 13 in der in Fig. 1 gezeigten Stellung, so ist die Erdleitung 10 nicht unterbrochen. Wird er jedoch teilweise herausgezogen, so dass er den Kontakt mit dem Leiterabschnitt 12 verliert, so wird die Erdleitung 10 unterbrochen.

Der vom Metallstift 13 und dem Leiterabschnitt 12 gebildete Schalter kann also durch die Kapselung 3 hindurch betätigt werden, so dass die Erdleitung 10 unterbrochen werden kann, ohne dass die Kapselung 3 geöffnet werden muss. Dieser Schalter kann jedoch auch in anderer Weise ausgestaltet werden. So kann z.B. ein anders geartetes bewegliches Element vorgesehen sein, welches sich durch eine Durchführung in der Kapselung erstreckt und in dieser beweglich gehalten ist, und mit dem der Schalter betätigt werden kann. Dieses bewegliche Element kann, wie in der Ausführung nach Fig. 1 gezeigt, gleichzeitig Teil der Erdleitung 10 bilden, es kann sich aber auch um ein isolierendes Element handeln, welches selbst nicht Teil der Erdleitung 10 bildet. Weitere Ausgestaltungen des Schalters 11 werden weiter unten unter Bezug auf die anderen Ausführungsbeispiele beschrieben.

Wie aus Fig. 1 weiter ersichtlich, ist zwischen dem zweiten Anschluss 8 des Varistors 5 und der Kapselung 3 zusätzlich ein elektrisch isolierender Körper 16 vorgesehen, an welchem in der vorliegenden Ausführung der Leiterabschnitt 12 und auch der Varistor 5 mechanisch abgestützt sind.

Weiter ist am zweiten Anschluss 8 eine Zusatzimpedanz 17 angeschlossen. Dabei handelt es sich um einen Widerstand oder einen Kondensator oder um eine Mischung derselben. Mit anderen Worten ist der Impedanzwert der Zusatzimpedanz also kapazitiv und/oder resistiv. Vorteilhaft nimmt der Impedanzwert bei zunehmender Spannung ab. Beispielsweise kann die Zusatzimpedanz 17 aus dem gleichen oder einem ähnlichen Material wie der Varistor 5 hergestellt sein. Sie braucht jedoch lediglich für geringere Leistungen bzw. Ströme ausgestaltet zu sein als der Varistor 5, da die Zusatzimpedanz nur während der weiter unten beschriebenen Testphase unter nennenswerter Spannung steht, nicht aber im Normalbetrieb.

Die Zusatzimpedanz ist elektrisch zwischen dem zweiten Anschluss 8 des Varistors 5 und einem Erdungsanschluss 18 des Überspannungsableiters 1 angeordnet. Der Erdungsanschluss 18 wird z.B. von der Kapselung 3 gebildet.

Im Folgenden wird nun beschrieben, wie bei einer Schaltungsanordnung 2 mit Überspannungsableiter 1 der in Fig. 1 gezeigten Art ein Überspannungstest durchgeführt werden kann. Im Wesentlichen das gleiche Verfahren kann auch bei den weiter unten beschriebenen weiteren Ausführungen des Überspannungsableiters 1 eingesetzt werden.

Um einen Überspannungstest durchzuführen, wird zunächst, vor der eigentlichen Testphase, die Erdleitung 10 unterbrochen. Im Ausführungsbeispiel nach Fig. 1 geschieht dies dadurch, dass der Metallstift 13 soweit nach aussen gezogen wird, dass er den Kontakt mit dem Leiterabschnitt 12 verliert und soweit von diesem entfernt wird, dass die Schaltanordnung 11 für die in der folgenden herrschenden Spannungen die Erdleitung 10 überschlagsfrei unterbricht.

Sodann findet die eigentliche Testphase statt. In dieser Testphase wird an mindestens einen Teil der spannungsführenden Teile der Schaltungsanordnung 2 eine Testspannung angelegt, die über der Nominalspannung derselben liegt. Beträgt die Nominalspannung z.B. 420 kV Phase-zu-Phase bzw. 242 kV Phase-zu-Erde, so wird eine Testspannung von 515 kV Phase-zu-Erde angelegt.

Diese Testspannung von 515 kV würde an sich die maximale Dauerspannung des Varistors 5, welche beispielsweise bei 317 kV liegt, deutlich überschreiten. Da nun jedoch die Erdleitung 10 unterbrochen ist, bilden der Varistor 5 und die Zusatzimpedanz 17 einen Spannungsteiler, so dass über dem Varistor 5 nur ein Teil der Testspannung anliegt. Konkret ist dabei die Zusatzimpedanz 17 so zu bemessen, dass der Spannungsabfall über dem Varistor 5 bei Anlegen der Testspannung die für die Prüfdauer maximal zulässige Spannung des Varistors 5 nicht überschreitet. Im obigen Zahlenbeispiel müssen über der Zusatzimpedanz 17 also mindestens 198 kV abfallen, d.h. die Zusatzimpedanz 17 darf nicht einen zu kleinen Impedanzwert besitzen.

Andererseits sollte der Impedanzwert der Zusatzimpedanz 17 auch nicht zu gross sein, da ansonsten der Spannungsabfall zwischen dem zweiten Anschluss 8 und Erde zu hoch wird und es zu Entladungen im unteren Teil des Überspannungsableiters kommen könnte, so z.B. über der Schaltanordnung 11.

Am Ende der Testphase wird nun die Testspannung von der Schaltungsanordnung 2 entfernt. Dann kann, nach der Testphase, die Unterbrechung der Erdleitung 10 wieder aufgehoben werden, indem die Schaltanordnung 11 durch Einschieben des Metallstifts 13 geschlossen wird. Nun kann der Normalbetrieb der Schaltungsanordnung 2 beginnen. Da dabei die Zusatzimpedanz über die Schaltanordnung 11 bzw. die Erdleitung 10 praktisch kurzgeschlossen wird, liegen allfällig auftretende Überspannungen voll über dem Varistor 5 an, während die schwächer dimensionierte Zusatzimpedanz 17 nicht belastet wird.

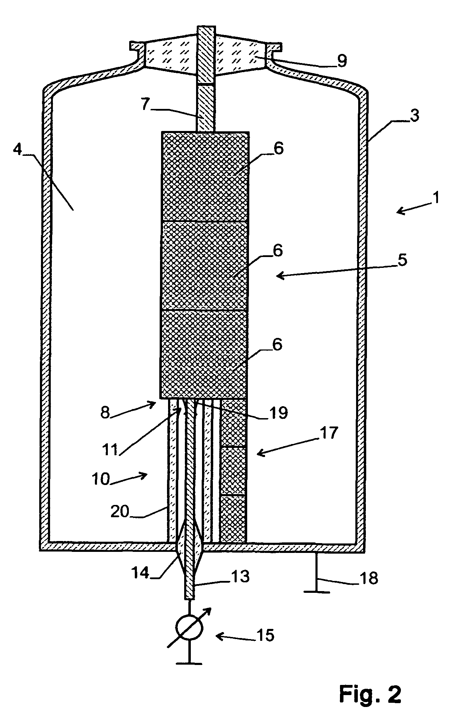

Fig. 2 zeigt eine zweite Ausführung eines Überspannungsableiters 1. Gegenüber der Ausführung von Fig. 1 unterscheidet sich diese Ausführung im Aufbau des unteren Teils, insbesondere in der Anordnung der Zusatzimpedanz 17 und der Erdleitung 10 bzw. der Schaltanordnung 11.

Zunächst ist, im Gegensatz zu Fig. 1, die Zusatzimpedanz 17 direkt mit dem zweiten Anschluss 8 bzw. dem unteren Ende des Varistors 5 verbunden und erstreckt sich zwischen dem Varistor 5 und dem geerdeten Boden der Kapselung 3.

Auch der Metallstift 13 kontaktiert den zweiten Anschluss 8 direkt oder über einen einfachen Kontaktmechanismus 19, so dass die Schaltanordnung 11 zwischen dem zweiten Anschluss 8 und dem Metallstift 13 gebildet wird. Wiederum ist der Metallstift 13 längsverschiebbar in einer gasdichten, elektrisch isolierenden Durchführung 14 der Kapselung 3 gehalten, so dass er teilweise aus der Kapselung herausgezogen werden kann, um die Schaltanordnung 11 zu öffnen.

Um den Metallstift 13 ist ein isolierender Stützkörper 20 angeordnet, welcher das untere Ende des Varistors 5 mit dem Boden der Kapselung 3 verbindet.

Die Funktionsweise der Ausführung nach Fig. 2 entspricht im Wesentlichen jener nach Fig. 1. So wird für die Testphase der Metallstift 13 teilweise aus der Kapselung 3 gezogen, so dass die Erdleitung 10 unterbrochen wird. Nun reduziert die Zusatzimpedanz 17 die Spannung über dem Varistor 5 und die Testspannung kann angelegt werden.

In der Ausführung nach Fig. 3 wird die Zusatzimpedanz 17 ausserhalb der Kapselung 3 angeordnet. Sie ist in einem Zusatzmodul 21 integriert, welches lediglich während den Überspannungstests benötigt wird. Im Normalbetrieb wird das Zusatzmodul 21 durch ein Erdungselement 28 ersetzt.

Damit die Spannung vom zweiten Anschluss 8 während der Testphase ohne Überschläge nach aussen geführt werden kann, ist in der Kapselung 3, insbesondere deren Boden, eine Hochspannungsdurchführung 22 vorgesehen, durch welche sich ein Leiter 23 vom zweiten Anschluss 8 zum Erdungsanschluss 18 erstreckt und die auf der Aussenseite der Kapselung 3 einen Aussenkonus bildet. Im Gegensatz zur Durchführung 14 der Ausführungen gemäss Fig. 1 und 2, muss die Hochspannungsdurchführung 22 in der Lage sein, während der Testphase der Spannung am zweiten Anschluss 8 standzuhalten. Andererseits kann der Leiter 23 fix in der Hochspannungsdurchführung 22 gehalten sein - eine Verschiebbarkeit bzw. Beweglichkeit, wie jene des Metallstifts 13 in der Durchführung 14 der Ausführung nach Fig. 1 oder 2, ist nicht erforderlich. Auch kann der Innenraum 4 minimal klein gehalten werden.

Das Zusatzmodul 21 kann verschieden ausgeführt sein und besitzt in Fig. 3 z.B. eine Kappe 24 aus Metall. Ein Flansch 25 der Kappe 24 kann während der Testphase über nicht gezeigte Befestigungsmittel mit dem Boden der Kapselung 3 verbunden werden. In der Kappe ist ein Raum zur Aufnahme der Zusatzimpedanz 17 vorgesehen, und zwar so, dass sich die Zusatzimpedanz 17 bei montiertem Zusatzmodul 21 zwischen der Kappe 24 und dem Erdungsanschluss 18 erstreckt. Um einen guten Kontakt zwischen Zusatzimpedanz 17 und Erdungsanschluss 18 zu gewährleisten, kann ein geeignetes federndes Kontaktelement 26 vorgesehen sein.

Der Raum seitlich zwischen Zusatzimpedanz 17 und Kappe 24 ist vorteilhaft mit einem Isolationsmittel 27 gefüllt. Dabei kann es sich um Silikon oder ein Gel handeln. Denkbar ist auch die Verwendung einer mit Schutzgas (z.B. SF₆) gefüllten Isolation.

Das Erdungselement 28 wird im Wesentlichen durch eine Metallplatte 29 gebildet, welche anstelle des Zusatzmoduls 21 am Überspannungsableiter 1 montiert werden kann. Die Form des Erdungselements 28 ist so gewählt, dass es nach seiner Montage mit dem Erdungsanschluss 18 verbunden ist, diesen abdeckt und ihn mit Erde verbindet, z.B. optional auch über eine Durchführung 31 sowie das Messgerät 15, oder über die Kapselung 3.

Bei der Ausführung nach Fig. 3 können das Erdungselement 28 und die Zusatzimpedanz 17 somit alternativ mit dem Erdungsanschluss 18 verbunden werden.

Vor der Testphase wird das Erdungselement 28 vom Überspannungsalbeiter 1 entfernt und durch das Zusatzmodul 21 ersetzt, so dass bei Anlegen der Testspannung der oben beschriebene Spannungsteiler aus Varistor 5 und Zusatzimpedanz 17 gegen Erde entsteht und die Zusatzimpedanz 17 einen Teil der Spannung übernehmen kann. Nach der Testphase wird das Zusatzmodul 21 entfernt und kann z.B. zurück zum Hersteller gehen, da es im Normalbetrieb nicht benötigt wird. Anstelle des Zusatzmoduls 21 wird das Erdungselement 28 montiert, welches nun zusammen mit dem Leiter 23 eine elektrische Verbindung vom zweiten Anschluss zur Erde bildet.

Somit wird in der Ausführung nach Fig. 3 die Erdleitung also vom Leiter 23 und dem Erdungselement 28 gebildet. Durch Entfernen des Erdungselements 28 kann diese Erdleitung unterbrochen werden, so dass das Erdungselement 28 als mechanische Schaltanordnung bezeichnet werden kann, mit welcher die Erdleitung unterbrechbar ist.

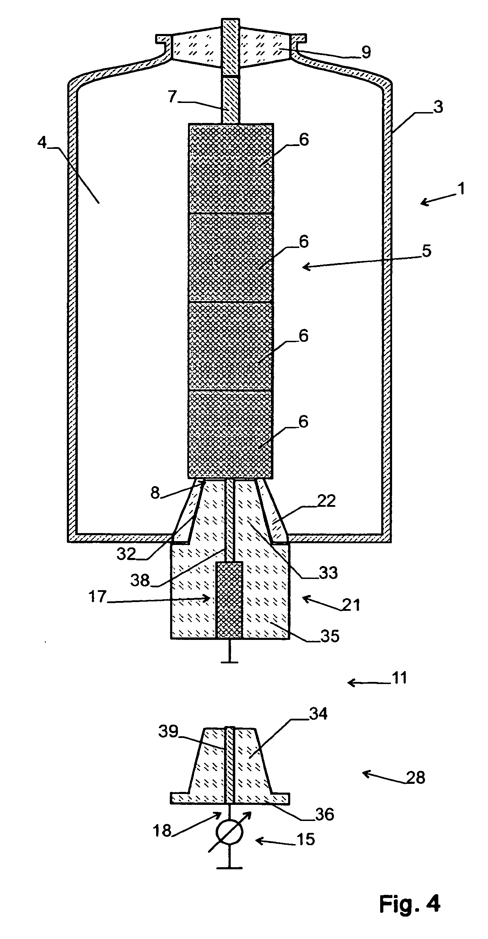

Fig. 4 zeigt eine Alternative zur Ausführung nach Fig. 3, bei welcher an der Unterseite des Überspannungsableiters 1 eine Vertiefung 32 (in Form eines Innenkonus) zum Varistor 5 hin ausgeformt ist, in welche das Zusatzmodul 21 oder das Erdungselement 28 eingesteckt werden können. Anstelle der Vertiefung 32 kann auch eine nach aussen ragende Aussenkontur vorgesehen sein, z.B. in Form eines Aussenkonus, auf welcher das Zusatzmodul 21 sitzt.

Das Zusatzmodul 21 besitzt in diesem Falle eine in die Vertiefung 32 passende Nase 33, und das Erdungselement 28 eine ebenfalls in die Vertiefung 32 passende Nase 34. Die Nase 33 bzw. 34 wird von einem Isolator 35 bzw. 36 gebildet. Der Isolator 35 bzw. 36 kann im Bereich ausserhalb der Kapselung 3 optional abgeschirmt sein.

Durch den Isolator 35 des Zusatzmoduls 21 erstreckt sich ein Leiter 38 zur Zusatzimpedanz 17. Durch den Isolator 36 des Erdungselements 28 erstreckt sich ein Leiter 39 zum Erdungsanschluss 18.

In der Ausführung gemäss Fig. 4 ist der Leiter 38 gerade und der Isolator 36 rotationssymmetrisch dargestellt, d.h. das Zusatzmodul 21 hat gerade Form. Das Zusatzmodul 21 kann z.B. jedoch auch, je nach Anforderung, z.B. L-förmig ausgestaltet sein, mit einem Körper, der um 90° gegenüber der Nase 33 abgewinkelt ist, oder das Zusatzmodul 21 kann ein flexibles Kabelstück sein oder ein solches enthalten. Dasselbe gilt für das Erdungselement 38.

In der Ausführung nach Fig. 4 kann als Zusatzmodul 21 z.B. ein Steckableiter bekannter Bauart zum Einsatz kommen.

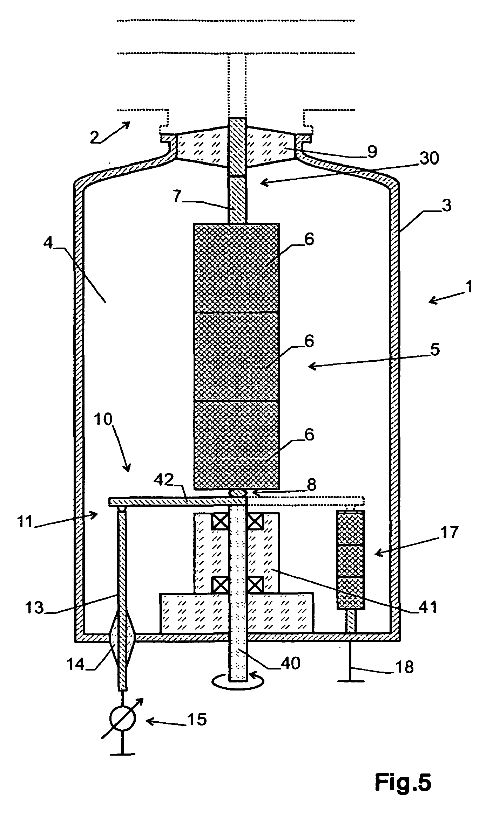

Fig. 5 zeigt eine Alternative zur Ausführung nach Fig. 1, bei welcher die Schaltandordnung 11 als Drehschalter ausgeführt ist. Hierzu ist an der Unterseite der Kapselung 3 eine Durchführung für ein Betätigungsglied 40 vorgesehen, welches um seine Längsachse drehbar in einem gasdichten Drehlager 41 gehalten wird. Am inneren Ende des Betätigungsglieds 40 ist ein elektrisch leitender Schwenkarm 42 befestigt, welcher an einem ersten Ende drehbar mit dem zweiten Anschluss 8 des Varistors verbunden ist, und dessen zweites Ende zwischen dem Metallstift 13 und der Zusatzimpedanz 17 hin- und her geschwenkt werden kann, um dort jeweils einen Kontakt herzustellen. In Fig. 5 ist der Schwenkarm 42 in derjenigen Position dargestellt, in welcher er den Metallstift 13 kontaktiert, während die Position, in welcher er die Zusatzimpedanz kontaktiert, gestrichelt dargestellt ist.

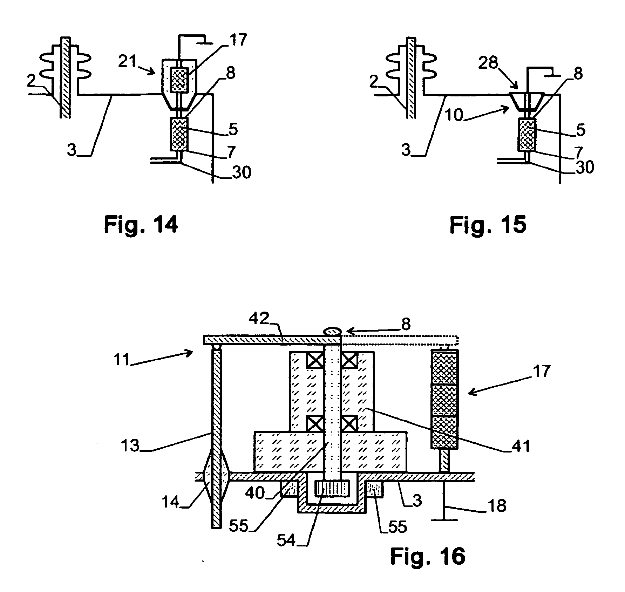

Während in der Ausführung nach Fig. 5 das Betätigungsglied 40 von ausserhalb der Kapselung gedreht wird, zeigt Fig. 16 eine Variante, bei welcher sich das Betätigungsglied 40 nicht durch die Kapselung 3 erstreckt. Vielmehr ist ein magnetischer Antrieb vorgesehen, der durch die Kapselung 3 hindurch wirkt. Hierzu ist am unteren Ende des Betätigungsglieds 40 ein Permanentmagnet 54 vorgesehen, der von einer Elektro- oder Permanent-Magnetanordnung 55 von ausserhalb der Kapselung gedreht werden kann, z.B. gegen die Kraft einer Torsionsfeder. Das magnetische Feld der Magnetanordnung 55 wirkt durch die Kapselung 3, welche z.B. aus Aluminium besteht.

Entsprechende permanent- oder elektromagnetische Anordnungen können auch zum Erzeugen von Linearbewegungen oder Kippbewegungen verwendet werden.

Die Elektromagnetanordnung 55 kann auch innerhalb der Kapselung 3 angeordnet werden.

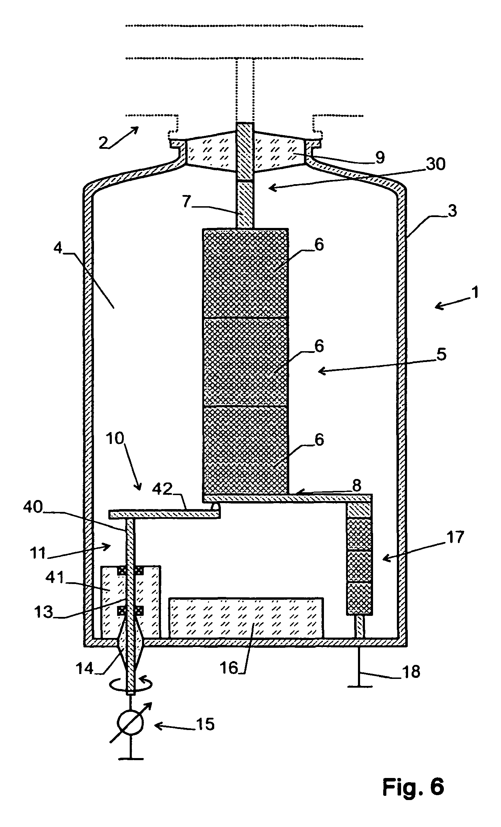

Wie in Fig. 6 dargestellt, kann das Betätigungsglied 40 auch vom Metallstift 13 gebildet werden. In diesem Fall ist das Drehlager 41 um den Metallstift 13 herum anzuordnen.

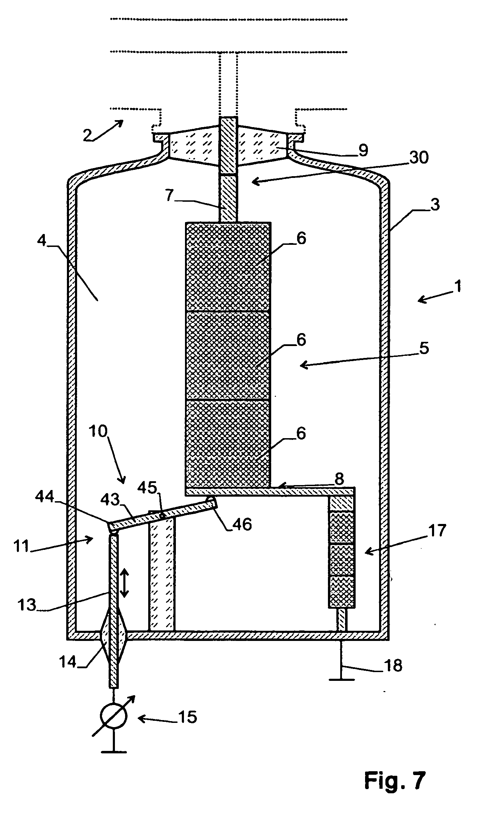

In der Ausführung nach Fig. 7 wurde der Schwenkarm 42 durch einen Kipparm 43 ersetzt, der durch eine Längsbewegung des Metallstifts 13 verkippt werden kann. Er ist z.B. an einem ersten Ende 44 gelenkig mit dem oberen Ende des Metallstifts 13 verbunden und in einem Kipplager 45 in seiner Mitte gehalten, so dass sein zweites Ende 46 durch eine Längsbewegung des Metallstifts 13 mit dem zweiten Anschluss 8 des Varistors 5 in Kontakt gebracht und von diesem wieder getrennt werden kann.

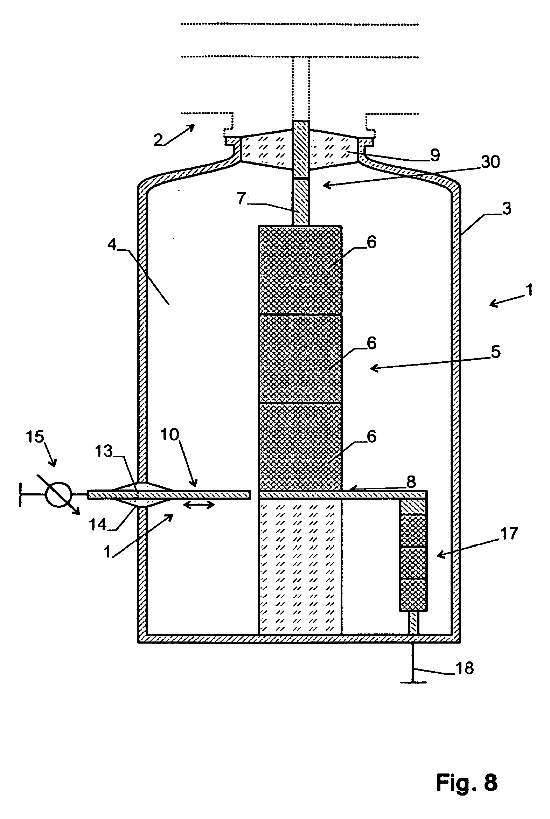

Eine weitere Variante ist in Fig. 8 dargestellt. Diese unterscheidet sich von der Ausführung nach Fig. 1 dadurch, dass der Metallstift 13 seitlich durch die Kapselung 3 geführt ist.

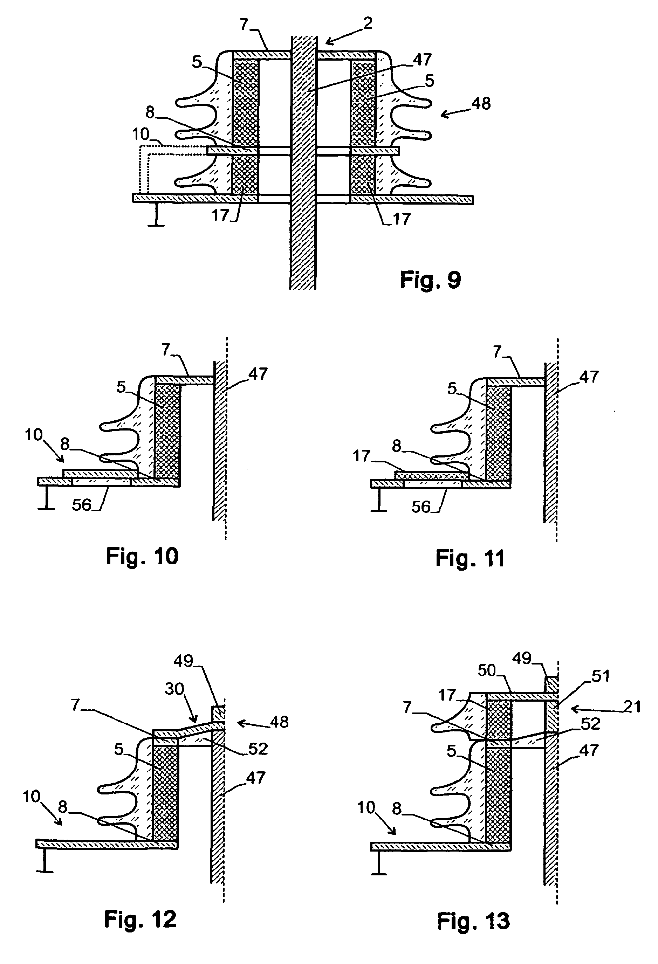

Fig. 9 zeigt schematisch einen Schnitt durch ein Bauteil in Form einer Hochspannungsdurchführung 48 mit integriertem Überspannungsableiter gemäss der vorliegenden Erfindung. In diesem Falle entspricht der Hochspannungsleiter 47 der "Schaltungsanordnung" 2. Der Varistor 5 ist beispielsweise zylindrisch um den Hochspannungsleiter 47 angeordnet. Der erste Anschluss 7 des Varistors 5 bildet eine Ringscheibe, welche sich radial nach innen bis zum Hochspannungsleiter 47 erstreckt. Der zweite Anschluss 8 wird ebenfalls von einer Ringscheibe gebildet, welche im Normalbetrieb über eine erste Leitung 10 (in Fig. 9 gestrichelt dargestellt) mit Erde verbunden ist. Auch die Zusatzimpedanz 17 ist beispielsweise zylindrisch um den Hochspannungsleiter 47 angeordnet und ist auf ihrer Hochspannungsseite mit dem zweiten Anschluss 8 und auf ihrer Erdungsseite mit Erde verbunden.

Während dem Normalbetrieb ist der zweite Anschluss 8, wie erwähnt, über die erste Leitung 10 mit Erde verbunden. Für den Testbetrieb wird die erste Leitung 10 unterbrochen, z.B. über einen Schalter oder indem sie ganz entfernt wird.

Fig. 10 und 11 zeigen eine zweite Ausführung einer Hochspannungsdurchführung. Diese ist wiederum im Wesentlichen zylindrisch ausgestaltet, weshalb in den Figuren nur eine Hälfte dargestellt ist.

Im Vergleich zur Ausführung gemäss Fig. 9 ist hier die Zusatzimpedanz 17 radial angeordnet und das Gehäuse 3 enthält eine Isolationsstrecke 56. Vorzugsweise wird sie, wie in den Figuren angedeutet, alternativ zur Erdungsleitung 10 zwischen dem zweiten Anschluss 8 und Erde eingefügt.

Fig. 12 und 13 zeigen eine dritte Ausführung einer Hochspannungsdurchführung.

Im Vergleich zu den bisher beschriebenen Ausführungen wird hier im Testbetrieb die Zusatzimpedanz 17 zwischen dem ersten Anschluss 7 des Varistors 5 und Hochspannung angeordnet. Diese Anordnung ist grundsätzlich nicht nur für Durchführungen sondern auch für alle anderen Anordnungen geeignet.

In der Ausführung nach Fig. 12 und 13 ist die Zusatzimpedanz 17 in einem Zusatzmodul 21 untergebracht, ähnlich wie in der Ausführung nach Fig. 3, und wird nur im Testbetrieb benötigt. Die isolierende Durchführung 52 ist beispielsweise als Aussenkonus ausgeführt. Im Normalbetrieb wird das Zusatzmodul 21 weg gelassen, und stattdessen ein Überbrückungselement 48, ähnlich dem Erdungselement 28 der Ausführung nach Fig. 3, eingesetzt.

In der Ausführung nach Fig. 12 und 13 liegt der zweite Anschluss 8 des Varistors 5 permanent auf Erde. Der erste Anschluss 7 liegt im Normalbetrieb über das Überbrückungselement 48, welches die erste Leitung 30 bildet, an Hochspannung. Das Überbrückungselement 48 ist in der vorliegenden Ausführung als kappenartiger Aufsatz der Hochspannungsdurchführung ausgestaltet und bildet einen mechanischen Anschluss 49 zum Anschliessen der externen Leitung.

Während der Testphase wird in der gezeigten Ausführung das Überbrückungselement 48 durch das Zusatzmodul 21 ersetzt, d.h. die erste Leitung 30 wird unterbrochen. Nun liegt der erste Anschluss 7 über die Zusatzimpedanz 17 auf Hochspannung. Hierzu ist das Zusatzmodul 21 so konstruiert, dass die Zusatzimpedanz 17 auf den ersten Anschluss 7 zu liegen kommt und auf ihrer gegenüber liegenden Seite über einen radialen Kontaktring 50 und einen achsialen Kontaktstab 51 mit der Hochspannungsleitung 47 verbunden ist. Zum Anschluss der externen Leitung bildet das Zusatzmodul 21 den mechanischen Anschluss 49.

In den Ausführungen nach Fig. 9 - 13 kann der Raum zwischen Varistor 5 und Hochspannungsleiter 47 mit Schutzgas oder einer Schutzflüssigkeit gefüllt sein, oder es kann an dieser Stelle ein isolierender Festkörper vorgesehen sein. Bei Verwendung eines gas- oder flüssigkeitgefüllten Zwischenraums sind zur mechanischen Stabilisierung und zur Abdichtung elektrisch isolierende Durchführungen 52 vorgesehen, siehe z.B. Fig. 12, 13.

Fig. 14 und 15 zeigen ein weiteres Hochspannungsbauteil 53 mit Überspannungsschutz. Beim Bauteil kann es sich z.B. um einen Transformator handeln.

Als Überspannungsschutz ist in bekannter Weise ein Varistor 5 vorgesehen. Im Normalbetrieb (Fig. 15) ist der erste Anschluss 7 des Varistors 5 über die erste Leitung 30 mit einer Hochspannung führenden Schaltungsanordnung 2 verbunden, und der zweite Anschluss 8 über eine zweite Leitung 10 mit Erde.

In der Ausführung nach Fig. 15 führt die zweite Leitung 10 durch ein Erdungselement 28, ähnlich wie in der Ausführung nach Fig. 4, das in eine Vertiefung in der Kapselung 3 des Bauteils eingesteckt ist. Durch Entfernen des Erdungselements 28 kann die zweite Leitung 10 unterbrochen werden.

Für die Testphase wird, wie in Fig. 14 gezeigt, das Erdungselement 28 durch ein Zusatzmodul 21 ersetzt, welches ungefähr gleich wie jenes nach Fig. 4 aufgebaut ist und die Zusatzimpedanz 17 enthält.

Zu beachten ist, dass die in den Figuren gezeigten Ausführungen noch in verschiedenster Weise variiert werden können.

So kann z.B. in der in Fig. 2 gezeigten Ausführung der Durchmesser der Zusatzimpedanz 17 jenem des Varistors 5 entsprechen, in welchem Falle der zweite Anschluss seitlich am nun eigentlich längeren Varistor abgegriffen werden kann. Dieser seitliche Abgriff kann dann z.B. mit einem Metallstift 13 der in Fig. 1 dargestellten Art kontaktiert werden.

Weiter ist zu beachten, dass die vorliegende Erfindung zwar im Zusammenhang mit gas-, flüssigkeitsoder feststoffisolierten Komponenten besonders vorteilhaft ist, da bei Tests keine Manipulationen erforderlich sind, die ein Ablassen des Schutzgases bzw. der Schutzflüssigkeit bedingen würden. Die Erfindung kann aber, wie oben anhand einiger Beispiele illustriert, auch für nicht gas-, flüssigkeits- oder feststoffisolierte Komponenten eingesetzt werden.

Besonders vorteilhaft wird die Erfindung auch bei einem Steckableiter verwendet, welcher erdungsseitig einen Steckanschluss der in Fig. 4 gezeigten Art besitzt. Hochspannungsseitig bildet der Steckableiter eine Nase, entsprechend der Nase 33 bzw. 34, und ist in eine Vertiefung des die Hochspannung führenden Bauteils eingesteckt.

Ist eine mechanische Schaltanordnung vorgesehen, so ist die Verwendung einer Elektromagnetanordnung 55, z.B. der in Fig. 16 gezeigten Art, von Vorteil. Die Verwendung einer Elektromagnetanordnung zur Betätigung der Schaltanordnung, welche bei allen Ausführungen der Schaltanordnung zum Einsatz kommen kann, hat den Vorteil, dass auf eine mechanisch bewegliche Durchführung durch die Kapselung 3 verzichtet werden kann.

Denkbar ist weiter auch, für die mechanische Betätigung der Schaltanordnung in der Kapselung einen beweglichen Faltenbalg vorzusehen, über welchen die Betätigung erfolgen kann. Auch diese Lösung kann völlig gasdicht ausgeführt werden.

Während in der vorliegenden Anmeldung bevorzugte Ausführungen der Erfindung beschrieben sind, ist klar darauf hinzuweisen, dass die Erfindung nicht auf diese beschränkt ist und in auch anderer Weise innerhalb des Umfangs der folgenden Ansprüche ausgeführt werden kann.

### Bezugsziffern

- 1:: Überspannungsableiter
- 2:: Schaltungsanordnung
- 3:: Kapselung
- 4:: Innenraum
- 5:: Varistor
- 6:: Einzelkörpern
- 7,8:: erster und zweiter Anschluss
- 9:: Durchführung
- 10:: zweite Leitung (Erdleitung)
- 11:: Schaltanordnung
- 12:: Leiterabschnitt
- 13:: Metallstift
- 14:: Durchführung
- 15:: Messgerät
- 16:: isolierender Körper
- 17:: Zusatzimpedanz
- 18:: Erdungsanschluss
- 19:: Kontaktmechanismus
- 20:: Stützkörper
- 21:: Zusatzmodul
- 22:: Hochspannungsdurchführung
- 23:: Leiter
- 24:: Kappe
- 25:: Flansch
- 26:: Kontaktelement
- 27:: Isolationsmittel
- 28:: Erdungselement
- 29:: Metallplatte
- 30:: erste Leitung
- 31:: Durchführung
- 32:: Vertiefung
- 33,: 34: Nase
- 35,: 36: Isolator
- 38,: 39: Leiter
- 40:: Betätigungsglied
- 41:: Drehlager
- 42:: Schwenkarm
- 43:: Kipparm
- 44:: erstes Ende des Kipparms
- 45:: Kipplager
- 46:: zweites Ende des Kipparms
- 47:: Hochspannungsleiter
- 48:: Überbrückungselement
- 49:: Anschluss
- 50:: Kontaktring
- 51:: Kontaktstab
- 52:: Durchführung
- 53:: Hochspannungsbauteil
- 54:: Permanentmagnet
- 55:: Magnetanordnung
- 56:: Isolationsstrecke

## Patentansprüche

1. Verfahren zum Durchführen eines Überspannungstests in einer Schaltungsanordnung (2), an welche mindestens ein Überspannungsableiter (1) angeschlossen ist, wobei der Überspannungsableiter (1) einen Varistor (5) aufweist, welcher in einem Normalbetrieb an einem ersten Anschluss (7) über eine erste Leitung (30) mit Hochspannungspotenzial und an einem zweiten Anschluss (8) über eine zweite Leitung (10) mit Erde verbunden ist, und wobei während einer Testphase eine Testspannung an die Schaltungsanordnung (2) angelegt wird, **dadurch gekennzeichnet, dass**
vor der Testphase die erste und/oder zweite Leitung (30, 10) unterbrochen wird,
während der Testphase der erste Anschluss (7) mit der Schaltungsanordnung (2) verbunden bleibt und der zweite Anschluss (8) über eine Zusatzimpedanz (17) mit Erde verbunden ist, oder der erste Anschluss über die Zusatzimpedanz (17) mit der Schaltungsanordnung (2) verbunden ist und der zweite Anschluss mit der Erde verbunden bleibt, oder der erste und der zweite Anschluss (7, 8) über jeweils eine Zusatzimpedanz (17) mit Erde bzw. der Schaltungsanordnung (2) verbunden sind, wobei die Zusatzimpedanz höhere Impedanz als die unterbrochene Leitung (30, 10) aufweist, und
nach der Testphase die Unterbrechung der ersten bzw, zweiten Leitung (30, 10) wieder aufgehoben wird.

2. Verfahren nach Anspruch 1, wobei während der Testphase die zweite Leitung (10) unterbrochen wird und der zweite Anschluss (8) über die Zusatzimpedanz (17) mit Erde verbunden ist.

3. Verfahren nach einem der vorangehenden Ansprüche, wobei die erste bzw. zweite Leitung (30,10) mittels einer mechanischen Schaltanordnung (11) unterbrochen wird.

4. Verfahren nach einem der vorangehenden Ansprüche, wobei die Zusatzimpedanz (17) derart bemessen wird, dass während der Testphase ein Spannungsabfall über dem Varistor (5) eine für eine Prüfdauer zulässige Spannung des Varistors (5) nicht übersteigt, während die Testspannung höher als die für die Prüfdauer zulässige Varistor-Maximalspannung ist.

5. Verfahren nach einem der vorangehenden Ansprüche, wobei die Schaltungsanordnung (2) eine gas-, flüssigkeits- oder feststoffisolierte Schaltungsanordnung und/oder der Überspannungsalbeiter (1) ein gas-, flüssigkeits- oder feststoffisolierter Überspannungsableiter ist.

6. Bauteil mit Überspannungsschutz zum Durchführen des Verfahrens nach einem der vorangehenden Ansprüche, umfassend
einen Varistor (5), welcher an einem ersten Anschluss (7) mit Hochspannungspotenzial und einem zweiten Anschluss (8) mit Erde verbindbar ist,
eine erste Leitung (30), über welche der erste Anschluss mit Hochspannungspotenzial verbindbar ist,
eine zweite Leitung (10), über welche der zweite Anschluss (8) mit Erde verbindbar ist,
**gekennzeichnet durch**
mindestens eine Zusatzimpedanz (17), welche eine höhere Impedanz als die erste oder zweite Leitung (10) aufweist, und welche zwischen dem ersten Anschluss (7) und der Hochspannung und/oder dem zweiten Anschluss (8) und der Erde anordenbar ist bzw. sind.

7. Bauteil nach Anspruch 6 mit einer mechanischen Schaltanordnung (11), mit welcher die erste oder zweite Leitung (30, 10) unterbrechbar ist.

8. Bauteil nach einem der Ansprüche 6 oder 7, wobei die Zusatzimpedanz (17) zwischen dem zweiten Anschluss und der Erde anordenbar ist oder angeordnet ist und die zweite Leitung (10) unterbrechbar ist.

9. Bauteil nach einem der Ansprüche 7 oder 8, wobei das Bauteil eine Kapselung (3) aufweist, insbesondere eine Kapselung, in welcher ein isolierendes Gas oder eine isolierende Flüssigkeit abgeschossen ist, wobei der Varistor (5) und die Zusatzimpedanz (17) in der Kapselung (3) angeordnet sind.

10. Bauteil nach Anspruch 9, wobei die Schaltanordnung (11) einen in der Kapselung (3) angeordneten Schalter (12, 13) aufweist, welcher durch die Kapselung (3) hindurch betätigbar ist.

11. Bauteil nach Anspruch 10, wobei der Schalter (12, 13) ein bewegliches Element (13) aufweist, welches sich durch die Kapselung (3) erstreckt und in einer gasdichten Durchführung (14) beweglich gehalten ist.

12. Bauteil nach Anspruch 11, wobei das bewegliche Element (13) elektrisch leitend ist und Teil der ersten oder zweiten Leitung (30,10) bildet.

13. Bauteil nach einem der Ansprüche 10 bis 12, wobei der Schalter (12, 13) ein bewegliches Element (13) aufweist, welches von einer Magnetanordnung (55) betätigbar ist.

14. Bauteil nach einem der Ansprüche 6 bis 8, wobei das Bauteil eine Kapselung (3) aufweist, insbesondere eine Kapselung, in welcher ein isolierendes Gas oder eine isolierende Flüssigkeit dicht abgeschossen ist, wobei der Varistor (5) in der Kapselung (3) angeordnet ist und wobei die Schaltanordnung (11) ausserhalb der Kapselung (3) angeordnet ist.

15. Bauteil nach Anspruch 14 mit einem elektrisch leitfähigen, entfernbaren Erdungselement (28), das zwischen dem zweiten Anschluss und Erde anordenbar ist, oder mit einem elektrisch leitfähigen, entfernbaren Überbrückungselement (48), welches zwischen dem ersten Anschluss und Hochspannungspotenzial anordenbar ist.

16. Bauteil nach Anspruch 15, wobei das Erdungselement (28) in eine Vertiefung (32) oder Aussenkontur des Bauteils einsteckbar ist.

17. Bauteil nach einem der Ansprüche 6 bis 15, wobei das Bauteil eine Kapselung (3) aufweist, insbesondere eine Kapselung, in welcher ein isolierendes Gas oder eine isolierende Flüssigkeit dicht abgeschossen ist, wobei der Varistor (5) in der Kapselung (3) angeordnet ist, und wobei die Zusatzimpedanz (17) ausserhalb der Kapselung (3) angeordnet ist.

18. Bauteil nach einem der Ansprüche 15 oder 16 und nach Anspruch 17, wobei die Zusatzimpedanz (17) in einem Zusatzmodul (21) angeordnet ist und wobei das Erdungselement (28) bzw. das Überbrückungselement (48) und das Zusatzmodul (21) alternativ an der Kapselung (3) anbringbar sind sind.

19. Bauteil nach einem der Ansprüche 6 bis 17, wobei die Zusatzimpedanz (17) zwischen dem zweiten Anschluss (8) und Erde anordenbar ist.

20. Bauteil nach einem der vorangehenden Ansprüche, wobei die Zusatzimpedanz (17) einen kapazitiven und/oder resistiven Impedanzwert aufweist.

21. Bauteil nach einem der Ansprüche 6 bis 20, wobei die Zusatzimpedanz (17) einen Impedanzwert aufweist, welcher bei zunehmender Spannung abnimmt.

22. Bauteil nach einem der Ansprüche 6 bis 21, wobei das Bauteil ein Überspannungsableiter oder eine Durchführung ist.

## Claims

1. Method for carrying out an overvoltage test in a circuit arrangement (2) to which at least one surge arrester (1) is connected, wherein the surge arrester (1) has a varistor (5), which is connected to high-voltage potential via a first line (30) at a first connection (7) and to ground via a second line (10) at a second connection (8) during normal operation, and wherein, during a test phase, a test voltage is applied to the circuit arrangement (2), **characterized in that**, before the test phase, the first and/or second lines/line (30, 10) are/is interrupted,
during the test phase, the first connection (7) remains connected to the circuit arrangement (2) and the second connection (8) is connected to ground via an additional impedance (17), or the first connection is connected to the circuit arrangement (2) via the additional impedance (17) and the second connection remains connected to ground, or the first and the second connection (7, 8) are respectively connected to ground and to the circuit arrangement (2) via a respective additional impedance (17), wherein the additional impedance has a higher impedance than the interrupted line (30, 10), and,
after the test phase, the interruption of the first and/or second lines/line (30, 10) are/is removed again.

2. Method according to Claim 1, wherein, during the test phase, the second line (10) is interrupted and the second connection (8) is connected to ground via the additional impedance (17).

3. Method according to one of the preceding claims, wherein the first and/or second lines/line (30, 10) are/is interrupted by means of a mechanical switching arrangement (11).

4. Method according to one of the preceding claims, wherein the additional impedance (17) is of such a size that, during the test phase, a voltage drop across the varistor (5) does not exceed a voltage on the varistor (5) which is permissible for a test duration, while the test voltage is higher than the maximum varistor voltage which is permissible for the test duration.

5. Method according to one of the preceding claims, wherein the circuit arrangement (2) is a gas-insulated, liquid-insulated or solid-insulated circuit arrangement, and/or the surge arrester (1) is a gas-insulated, liquid-insulated or solid-insulated surge arrester.

6. Device having overvoltage protection for carrying out the method according to one of the preceding claims, comprising
a varistor (5) which can be connected to high-voltage potential at a first connection (7) and can be connected to ground at a second connection (8),
a first line (30), via which the first connection can be connected to high-voltage potential,
a second line (10), via which the second connection (8) can be connected to ground,
**characterized by**
at least one additional impedance (17), which has a higher impedance than the first or second line (10) and which can be arranged between the first connection (7) and the high voltage, and/or between the second connection (8) and ground.

7. Device according to Claim 6 having a mechanical switching arrangement (11) by means of which the first or second line (30, 10) can be interrupted.

8. Device according to one of Claims 6 or 7, wherein the additional impedance (17) can be arranged or is arranged between the second connection and ground, and the second line (10) can be interrupted.

9. Device according to one of Claims 7 or 8, wherein the component has encapsulation (3), in particular encapsulation in which an insulating gas or an insulating liquid is enclosed, wherein the varistor (5) and the additional impedance (17) are arranged in the encapsulation (3).

10. Device according to Claim 9, wherein the switching arrangement (11) has a switch (12, 13) which is arranged in the encapsulation (3) and can be operated through the encapsulation (3).

11. Device according to Claim 10, wherein the switch (12, 13) has a moving element (13) which extends through the encapsulation (3) and is held movably in a gas-tight bushing (14).

12. Device according to Claim 11, wherein the movable element (13) is electrically conductive and forms part of the first or second line (30, 10).

13. Device according to one of Claims 10 to 12, wherein the switch (12, 13) has a movable element (13) which can be operated by a magnet arrangement (55).

14. Device according to one of Claims 6 to 8, wherein the device has encapsulation (3), in particular encapsulation in which an insulating gas or an insulating liquid is enclosed in a sealed manner, wherein the varistor (5) is arranged in the encapsulation (3), and wherein the switching arrangement (11) is arranged outside the encapsulation (3).

15. Device according to Claim 14 having an electrically conductive, removable grounding element (28), which can be arranged between the second connection and ground, or having an electrically conductive, removable bridging element (48), which can be arranged between the first connection and high-voltage potential.

16. Device according to Claim 15, wherein the grounding element (28) can be inserted into a depression (32) or an external contour of the device.

17. Device according to one of Claims 6 to 15, wherein the device has encapsulation (3), in particular encapsulation in which an insulating gas or an insulating liquid is enclosed in a sealed manner, wherein the varistor (5) is arranged in the encapsulation (3), and wherein the additional impedance (17) is arranged outside the encapsulation (3).

18. Device according to one of Claims 15 or 16 and according to Claim 17, wherein the additional impedance (17) is arranged in an additional module (21), and wherein the grounding element (28) and/or the bridging element (48) and the additional module (21) can alternatively be fitted to the encapsulation (3).

19. Device according to one of Claims 6 to 17, wherein the additional impedance (17) can be arranged between the second connection (8) and ground.

20. Device according to one of the preceding claims, wherein the additional impedance (17) has a capacitive and/or resistive impedance value.

21. Device according to one of Claims 6 to 20, wherein the additional impedance (17) has an impedance value which decreases as the voltage increases.

22. Device according to one of Claims 6 to 21, wherein the device is a surge arrester or a bushing.

## Revendications

1. Procédé destiné à la réalisation d'un test de surtension dans un agencement de circuits (2), auquel est raccordé au moins un disjoncteur de surtension (1), le disjoncteur de surtension (1) comportant un variateur (5), qui lors d'un fonctionnement normal est connecté à un premier raccord (7) par l'intermédiaire d'un premier conduit (30) à potentiel haute tension et à un deuxième raccord (8), par l'intermédiaire d'un deuxième conduit (10) équipé de la terre et pendant une phase de test, une tension de test étant appliquée sur l'agencement de circuits (2), **caractérisé en ce que**
avant la phase de test, on interrompt le premier et/ou le deuxième conduit (30, 10) ;
pendant la phase de test, le premier raccord (7) reste relié à l'agencement de circuits (2) et le deuxième raccord (8) est relié à la terre par l'intermédiaire d'une impédance supplémentaire (17) ou le premier raccord est relié à l'agencement de circuits (2) par l'intermédiaire de l'impédance supplémentaire (17) et le deuxième raccord reste relié à la terre ou le premier et le deuxième raccord (7, 8) sont reliés à la terre ou à l'agencement de circuits (2), chacun par l'intermédiaire d'une impédance supplémentaire (17), l'impédance supplémentaire présentant une impédance supérieure à celle du conduit (30, 10) interrompu et
après la phase de test, on annule de nouveau l'interruption du premier ou du deuxième conduit (30, 10).

2. Procédé selon la revendication 1, lors duquel, pendant la phase de test, on interrompt le deuxième conduit (10), le deuxième raccord (8) étant relié à la terre par l'intermédiaire de l'impédance supplémentaire (17).

3. Procédé selon l'une quelconque des revendications précédentes, lors duquel on interrompt le premier ou le deuxième conduit (30, 10) au moyen d'un agencement de commutation mécanique (11).

4. Procédé selon l'une quelconque des revendications précédentes, l'impédance supplémentaire (17) étant dimensionnée de telle sorte que pendant la phase de test, une chute de tension par l'intermédiaire du variateur (5) ne dépasse pas la tension du variateur (5) autorisée pour une durée d'essai, alors que la tension de test est supérieure à la tension maximale du variateur autorisée pour la durée d'essai.

5. Procédé selon l'une quelconque des revendications précédentes, l'agencement de circuits (2) étant un agencement de circuits isolé des gaz, des liquides ou des solides et/ou le disjoncteur de surtension (1) étant un disjoncteur de surtension isolé des gaz, des liquides ou des solides.

6. Composant avec coupe-circuit de surtension pour la réalisation du procédé selon l'une quelconque des revendications précédentes, comprenant
un variateur (5) susceptible d'être relié à un premier raccord (7) avec un potentiel haute tension et à un deuxième raccord (8) muni de la terre,
un premier conduit (30) par l'intermédiaire duquel le premier raccord est susceptible d'être relié à un potentiel haute tension,
un deuxième conduit (10) par l'intermédiaire duquel le deuxième raccord (8) est susceptible d'être relié à la terre,
**caractérisé par**
au moins une impédance supplémentaire (17) qui présente une impédance supérieure à celle du premier ou du deuxième conduit (10) et qui est susceptible d'être disposée entre le premier raccord (7) et la haute tension et/ou le deuxième raccord (8) et la terre.

7. Composant selon la revendication 6, avec un agencement de commutation (11) mécanique, à l'aide duquel le premier ou le deuxième conduit (30, 10) peut être interrompu.

8. Composant selon l'une quelconque des revendications 6 ou 7, l'impédance supplémentaire (17) étant susceptible d'être ou étant disposée entre le deuxième raccord et la terre et le deuxième conduit (10) étant susceptible d'être interrompu.

9. Composant selon l'une quelconque des revendications 7 ou 8, le composant comportant un blindage (3), notamment un blindage dans lequel un gaz isolant ou un liquide isolant est contenu, le variateur (5) et l'impédance supplémentaire (17) étant disposés dans le blindage (3).

10. Composant selon la revendication 9, l'agencement de commutation (11) comportant un commutateur (12, 13) disposé dans le blindage (3) qui est susceptible d'être manoeuvré à travers le blindage (3).

11. Composant selon la revendication 10, le commutateur (12, 13) comportant un élément mobile (13) qui s'étend à travers le blindage (3) et qui est maintenu tout en étant mobile dans un passage étanche (14) au gaz.

12. Composant selon la revendication 11, l'élément mobile (13) étant conducteur d'électricité et formant une partie du premier ou du deuxième conduit (30, 10).

13. Composant selon l'une quelconque des revendications 10 à 12, le commutateur (12, 13) comportant un élément mobile (13) qui est susceptible d'être manoeuvré par un agencement d'aimants (55).

14. Composant selon l'une quelconque des revendications 6 à 8, le composant comportant un blindage (3), notamment un blindage dans lequel un gaz isolant ou un liquide isolant est contenu de manière étanche, le variateur (5) étant disposé dans le blindage (3) et l'agencement de commutation (11) étant disposé à l'extérieur du blindage (3).

15. Composant selon la revendication 14, avec un élément de mise à la terre (28) conducteur d'électricité amovible, qui est susceptible d'être disposé entre le deuxième raccord et la terre, ou avec un élément de pontage (48) qui est susceptible d'être disposé entre le premier raccord et le potentiel haute tension.

16. Composant selon la revendication 15, l'élément de mise à la terre (28) étant susceptible d'être inséré dans un creux (32) ou un contour extérieur du composant.

17. Composant selon l'une quelconque des revendications 6 à 8, le composant comportant un blindage (3), notamment un blindage dans lequel un gaz isolant ou un liquide isolant est contenu de manière étanche, le variateur (5) étant disposé dans le blindage (3) et l'impédance supplémentaire (17) étant disposée à l'extérieur du blindage (3).

18. Composant selon l'une quelconque des revendications 15 ou 16 ou selon la revendication 17, l'impédance supplémentaire (17) étant disposée dans un module supplémentaire (21) et l'élément de mise à la terre (28) ou l'élément de pontage (48) et le module supplémentaire (21) étant susceptibles d'être montés en alternative sur le blindage (3).

19. Composant selon l'une quelconque des revendications 6 à 17, l'impédance supplémentaire (17) étant susceptible d'être disposée entre le deuxième raccord (8) et la terre.

20. Composant selon l'une quelconque des revendications précédentes, l'impédance supplémentaire (17) présentant une valeur d'impédance capacitive et/ou résistive.

21. Composant selon l'une quelconque des revendications 6 à 20, l'impédance supplémentaire (17) présentant une valeur d'impédance qui décroît au fur et à mesure que la tension augmente.

22. Composant selon l'une quelconque des revendications 6 à 21, le composant étant un disjoncteur de surtension ou un passage.
